# EUROPEAN PATENT APPLICATION

(11) **EP 4 550 958 A1**
(43) Date of publication of application: **07.05.2025**
(21) Application number: 24209904.2
(22) Date of filing: 30.10.2024
(51) Int. Cl.: H05K 7/20, G06F 17/40, F24F 11/46, F24F 11/62, F24F 11/63, F24F 11/64

(54) **THERMAL OPTIMIZATION FOR DATA CENTERS**

(30) Priority: 31.10.2023 US 202363594457 P
(71) Applicant: Carrier Corporation, Palm Beach Gardens, FL 33418 (US)
(72) Inventor: CAI, Weihua, Kennesaw, 30144 (US); PIETRZYKOWSKI, Christopher, Friendship, 04547 (US); JACOBSON, Clas, Manchester, 06042 (US); GRABON, Michel, 011220 Montluel (FR); ELBSAT, Mohammad, Palm Beach Gardens, 33418 (US); ÅKESSON, Johan, 42243 Hisings Backa (SE); FORTINGTON-NEAVE, Robert, Kennesaw, 30144 (US); GRECO, Enzo, Kennesaw, 30144 (US)
(74) Representative: Dehns

(57) **Abstract**

A thermal optimization control (32) includes processing circuitry. The processing circuitry is operable to receive information from a building (20) housing at least one computer server, with the information including at least current thermal load. The processing circuitry is operable to control an associated HVAC system for at least an area (22) of the building (20) where the at least one computer server is housed. The processing circuity is operable to optimize the operation of the HVAC system based upon the current and an expected upcoming thermal load on the area (22) of the building (20) where the server is received to reduce energy usage by the HVAC system. A method and building (20) are also disclosed.

## Description

### BACKGROUND

This invention relates to optimization of the thermal conditioning for buildings housing data centers.

A modern development is the existence of data centers. Data centers typically include any number of computer servers, and other electronic devices. Maintaining the proper temperatures in a building operating as a data center, or an area of a building having data center components, is important.

Thus, it is known to provide heating ventilation and air conditioning ("HVAC") for such buildings. One type HVAC is a so called water chiller. Typically various areas in such a building are provided with a temperature setpoint, and the water chiller acts to maintain that setpoint for the particular area.

### SUMMARY

According to a first aspect of the invention there is provided a thermal optimization control. The thermal optimization control includes processing circuitry. The processing circuitry is operable to receive information from a building housing at least one computer server, with the information including at least current thermal load. The processing circuitry is operable to control an associated HVAC system for at least an area of the building where the at least one computer server is housed. The processing circuity is operable to optimize the operation of the HVAC system based upon the current and an expected upcoming thermal load on the area of the building where the server is received to reduce energy usage by the HVAC system.

According to further aspects of the invention a method and a building including a thermal optimization control are also disclosed.

These and other features will be best understood from the following drawings and specification, the following is a brief description.

### BRIEF DESCRIPTION OF THE DRAWINGS

Certain exemplary embodiments will now be described in greater detail by way of example only and with reference to the accompanying drawings in which:
Figure 1 schematically shows a building having data center components.
Figure 2 shows aspect of a thermal optimization for a building such as in Figure 1.
Figure 3 is a schematic of a system for utilizing a method of this disclosure.
Figure 4 shows various degrees of optimization with the present disclosure.
Figure 5 is a brief flow chart of a method according to this disclosure.

### DETAILED DESCRIPTION

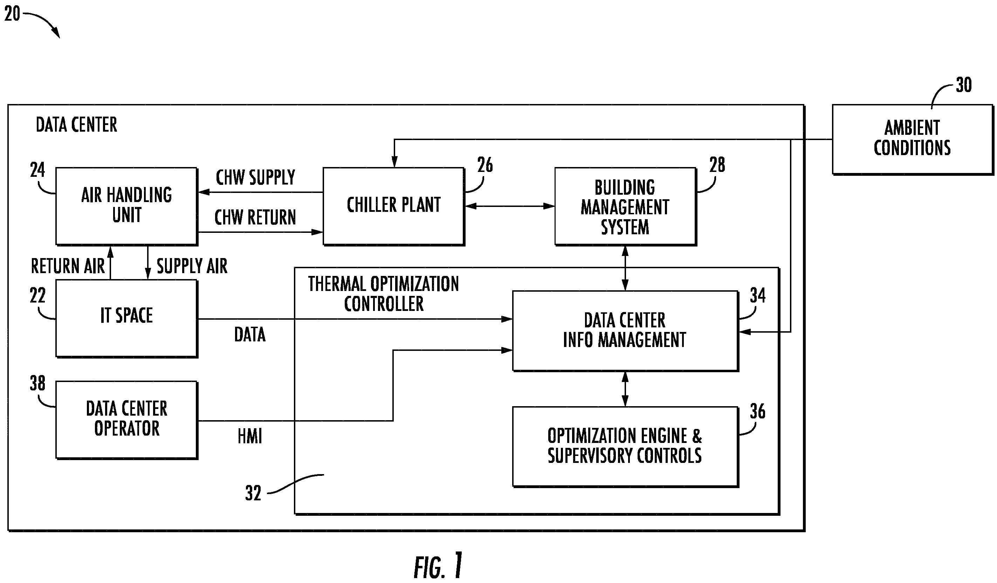

A building 20 is illustrated in Figure 1. Building 20 has IT space 22. The IT space would be an area(s) housing servers and potentially other electronic equipment that will generate heat. An air handling unit 24 delivers air into the IT space 22 to maintain a desired temperature level.

A water chiller 26 is shown for supplying water to cool the air delivered from the air handling unit 24 into the IT space 22. A building management system 28 controls the water chiller to achieve a desired air temperature and flow moving into the IT space 22.

As shown, an ambient condition sensor 30 delivers a signal into the water chiller 26, and into a thermal optimization control 32. Thermal optimization control 32 includes a data center info management system 34. The data center info management system 34 receives a signal from the IT space 22, and from a data center operator 38. Data center operator 38 allows input of data center conditions from an operator to the data center info management system 34.

As an example, the data center operator 38 can send input signals of anticipated scheduling for operations that will be performed at various locations within the IT space 22. The data center operator 38 may also allow an individual to override a temperature optimized by the thermal optimization control 32. As an example, should an optimized temperature be lower or higher than the operator may desire, a signal may be sent to override the determined optimized temperature.

Element 36 is an optimization engine and supervisory controls.

In the prior art, a temperature is selected for various locations within the building, and the water chiller is operated to achieve those present temperatures. The load on different locations in the IT space 22 can change over time. As an example, there may be a server in one area of the IT space 22 that is performing a large amount of work at a particular time, while other servers are operating at a lower level. Thus, the heat loads at various spaces within the IT space 22 may vary.

It would be desirable to optimize the thermal management to achieve energy savings. To this end, data center HVAC setpoints can be varied versus remaining fixed per the above-mentioned design standard. Multiple thermal units can be managed cohesively in this manner so that they cooperate to achieve energy savings.

In one main aspect of this disclosure, real-time and predicted IT load data may be utilized by the thermal management optimization control 32 to optimize the thermal management and resulting energy use.

The disclosed system uses the real-time IT data to predict upcoming IT demand in a data center, and dynamically aligns thermal capacity with demand. In this manner, the disclosed system optimizes the chiller plant operating efficiency and provides supervisory control over data center operations.

By addressing these issues, more efficient data center life cycle thermal management can be achieved. Organizations can achieve improved operation efficiency, reduced cost, enhance equipment reliability and increase sustainability in their data center operations.

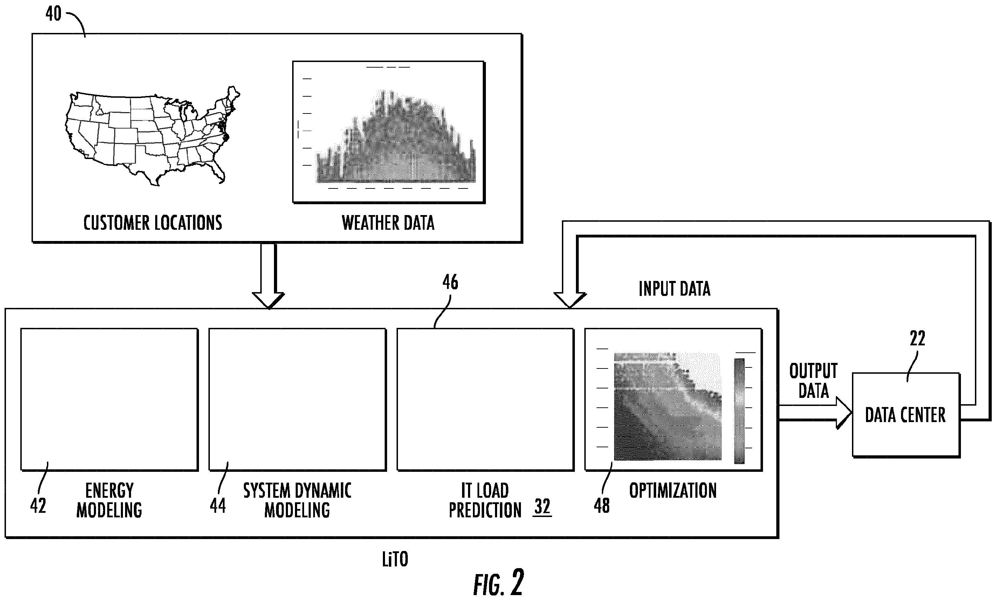

Figure 2 is an overview of the operation under the disclosed method. As shown, the thermal optimization control 32 receives input shown at 40 from customer locations and associated weather data. Energy modeling is performed as shown schematically at 42. In addition, system dynamic modeling is performed as shown schematically at element 44. IT load prediction is performed at 46, and optimization is performed at 48 based upon inputs 40, 42, 44 and 46. Input data is also received at the thermal optimization control 32 from the IT space 22 itself.

The load prediction can be based upon historic data, the time of day, date, month or day of the week. Moreover, an operator may input upcoming IT events to assist with the prediction. As an example of historic data, it may be that a company performs a particular large IT intensive function on a particular day of the month. As one example, perhaps bills are mailed on the first Monday of a month. The historic data would store this, and utilize this to help anticipate a thermal load on the associated part of the IT space 22.

The energy modeling 42 captures power consumption modeling and energy consumption for the HVAC system, and in particular the water chiller 26. The system dynamic modeling 44 will capture system dynamics.

As examples of optimization, assuming the building 20 is provided with three water chillers, the optimization may include a decision to operate all 3 on part load, or shutdown one and operate two on full load. Moreover, the volume of water passing from the chiller plant 26 to the air handling unit 24 may be varied to minimize energy consumption.

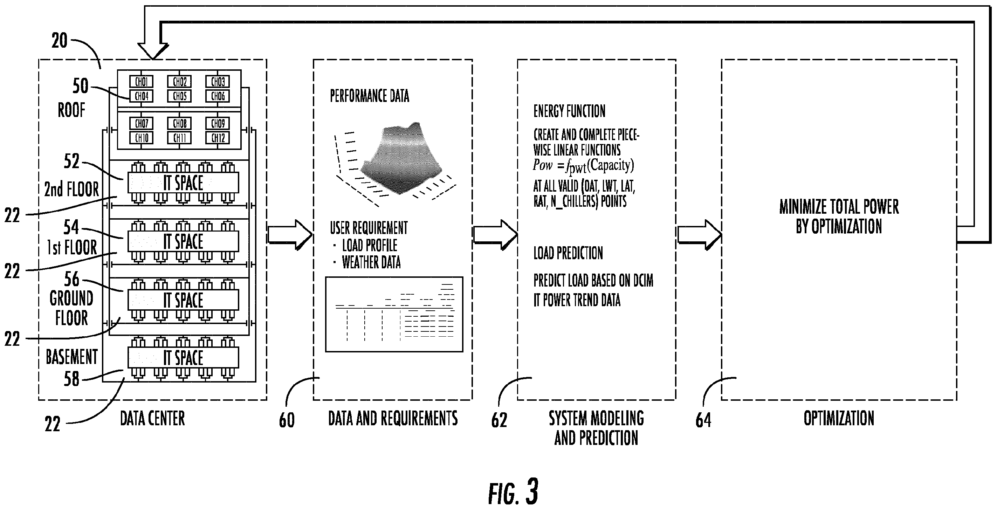

Figure 3 is an example diagram showing the overall control of this disclosure. As shown, the building 20 may include rooftop HVAC systems 50, which may be water chillers. As can be seen, there may be a plurality of chillers, and illustrated here as 12.

There are also four floors 52, 54, 56, 58 which carry IT spaces 22. It should be appreciated that the load across the several floors will vary over time and relative to each other. As an example, perhaps the IT space 22 on floor 56 will be performing a large task beginning an hour from now. That would be taken into account by the thermal optimization control 32, and factored into the optimization.

At 60, data and requirements are considered including a load profile of upcoming thermal loads, ambient weather, etc.

Next at 62 an energy function and a load prediction are considered. This may include creating and computing piece-wise linear function at all valid points such as outside air temperature, water temperatures, the number of chillers being utilized, etc. Next, the optimization occurs at 64. Note, non-linear functions may be used.

The objective for the optimization is to reduce energy consumptions with system constraints. The optimized actions include the number of chiller staging, leaving chilled water temperature (LWT), chilled water differential pressure, CRAH/C supply air temperature (SAT), or leaving air temperature.

As shown at 62, an energy function utilizes a number of pieces of information as described above. A load prediction is also utilized and may be received from a data center infrastructure management system. The information could include historic load information and current load information. The historic load information could come with a timestamp from which the controller can determine time of day, day of the week, year and month.

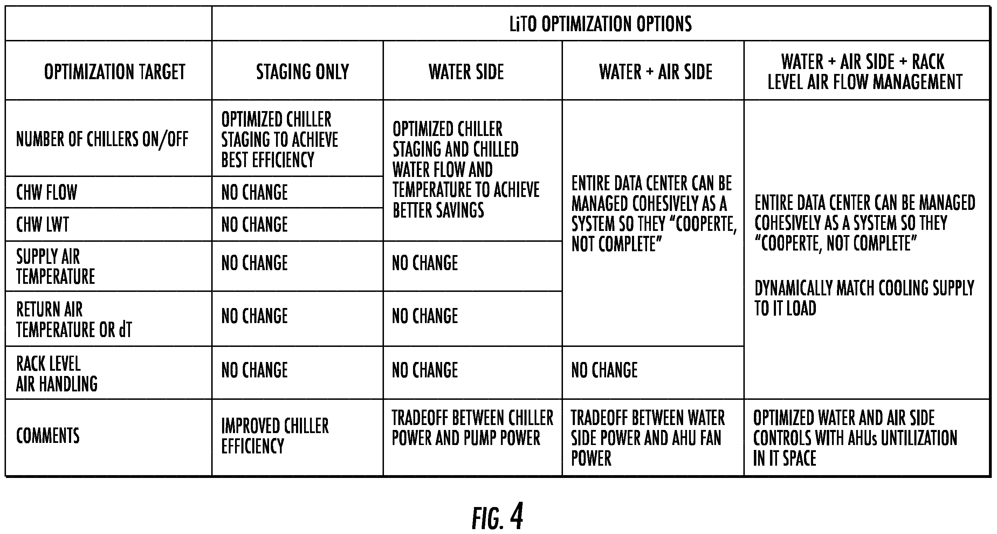

Figure 4 schematically shows options for step wise optimizing the thermal handling of a building. There are several possible steps along the way.

As an example, the staging or on/off state of the chillers may be the only step. As a second more extensive step the chiller staging may be optimized along with controlling a chiller water flow and temperature to achieve better savings. As yet another potential step, the entire data center can be managed cohesively as a system including controlling the volume of air and temperature of air, and controlling the HVAC system in this manner such that the several items cooperate to achieve the optimized operation, and not to compete. A volume of air delivered into the building may be controlled by controlling a fan for delivering the air into the building to reduce energy consumptions. Finally, and a further step, each of the above can be done along with rack level airflow management to components within servers or other electronic components in the IT space.

For example, if the IT load predicts a certain row of racks will increase in the prediction horizon, we can increase the air flow in that row. Or if there is schedule maintenance shutdown of the servers in certain racks, one can reduce the air flow in that IT space.

Notably, the term "CHW" refers to chiller water. The "T"s refer to temperature.

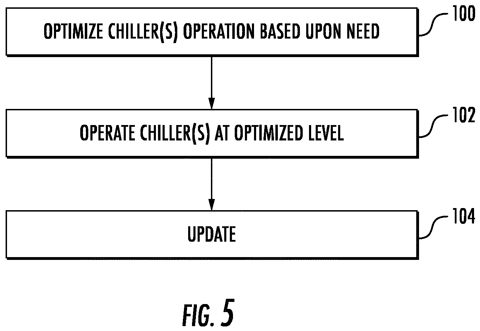

Figure 5 is a flow chart of the method according to this disclosure. At step 100, the HVAC system operation is optimized based upon current conditions in several locations within an IT space based upon current need and predicted need. At step 102 the chillers are operated at the optimized level. At step 104, the control continues to update the operation as conditions change.

A thermal optimization control under this disclosure could be said to include processing circuitry. The processing circuitry is operable to receive information from a building housing at least one computer server, with the information including at least a current thermal load. The processing circuitry is operable to control an associated HVAC system for at least an area of the building where the at least one computer server is housed. The processing circuity is operable to optimize the operation of the HVAC system based upon the current thermal load and an expected upcoming thermal load on the area of the building where the server is received to reduce energy usage by the HVAC system.

The load information could be related to the thermal load and/or an associated power load for the IT system.

A method of optimizing thermal conditioning under this disclosure could be said to include receiving information from a building housing at least one computer server, with the information including at least current thermal load. Thermal load information from the building is used to control an associated HVAC system for at least an area of the building where the at least one computer server is housed. Operation of the HVAC system is optimized based upon the current thermal load on the area of the building where the at least one computer server is housed to reduce energy usage by the HVAC system.

The HVAC system is typically on the building roof. However, in some applications that benefit from this disclosure the HVAC system could be remote from the building.

Although embodiments have been disclosed, a worker of skill in this art would recognize that modifications would come within the scope of this invention, which is as defined by the appended claims. For that reason, the following claims should be studied to determine the true scope of the invention.

## Claims

1. A thermal optimization control (32) comprising:
processing circuitry;
the processing circuitry being operable to receive information from a building (20) housing at least one computer server, with the information including at least a current thermal load;
the processing circuitry being operable to control an associated HVAC system for at least an area (22) of the building (20) where the at least one computer server is housed; and
the processing circuity being operable to optimize the operation of the HVAC system based upon the current thermal load and an expected upcoming thermal load on the area (22) of the building (20) where the server is received to reduce energy usage by the HVAC system.

2. The control (32) as set forth in claim 1, wherein the optimization includes controlling a staging of a plurality of HVAC systems between on/off conditions and/or full load/partial load; and/or
wherein the optimization further includes controlling a volumetric flow and temperature of water delivered from one or more water chillers (26) to an air handling unit (24) to optimize and reduce energy consumption.

3. The control (32) as set forth in any preceding claim, wherein there are a plurality of the computer servers, and there are a plurality of areas (22) in the building (20) housing the plurality of computer servers.

4. The control (32) as set forth in any preceding claim, wherein the thermal optimization control further has a memory being provided with historic thermal load information from the building (20).

5. A method of optimizing thermal conditioning comprising:
receiving information from a building (20) housing at least one computer server, with the information including at least current thermal load;
using thermal load information from the building (20) to control an associated HVAC system for at least an area (22) of the building (20) where the at least one computer server is housed; and
optimizing (100) operation of the HVAC system based upon the current thermal load on the area (22) of the building (20) where the at least one computer server is housed to reduce energy usage by the HVAC system.

6. The method as set forth in claim 5, wherein the HVAC system includes a plurality of water chillers (26) for cooling air to be delivered from an air handling unit (24) into the area (22) of the building (20) that houses the at least one computer server.

7. The method as set forth in claim 6, wherein there are a plurality of the computer servers and a plurality of areas (22) in the building (20) receiving the plurality of computer servers.

8. The method as set forth in claim 7, wherein the optimization includes controlling a staging of the plurality of water chillers (26) between on/off conditions and/or full load/partial load.

9. The method as set forth in claim 8, wherein the optimization further includes controlling a volumetric flow and temperature of water delivered from the water chillers (26) to the air handling unit (24) to optimize and reduce energy consumption.

10. The method as set forth in claim 9, wherein a volume of air delivered into the building (20) is controlled by controlling a fan for delivering air into the building (20) to reduce energy consumptions, optionally wherein air flow is managed at a rack level within the plurality of servers to reduce energy consumption.

11. The method as set forth in any of claims 5 to 10, further including the step of using historic data in the optimization, optionally
wherein the historic data includes prior load information.

12. The method as set forth in claim 11, further including receiving information from an operator associated with the area (22) of the building (20) receiving the plurality of computer servers and controlling the HVAC system based upon the information received from the operator.

13. A building (20) comprising:
an area (22) housing at least one computer server;
a HVAC system for the building (20); and
a thermal optimization control (32) having processing circuitry, the processing circuitry being operable to receive information from the building (20), with the information including at least a current thermal load, the processing circuitry being operable to control the HVAC system for at least an area (22) of the building (20) where the at least one computer server is housed; and
the processing circuity being operable to optimize the operation of the HVAC system based upon the current thermal load on the area (22) of the building (20) where the server is received to reduce energy usage by the HVAC system.

14. The building (20) as set forth in claim 13, wherein the HVAC system includes a plurality of water chillers (26) for cooling air to be delivered into the area (22) of the building (20) that houses the at least one computer server, and/or
wherein there are a plurality of the computer servers, and there are a plurality of areas (22) in the building (20) receiving the plurality of computer servers.

15. The building (20) as set forth in claim 13 or 14, wherein the thermal optimization control also has a memory with historic data on the thermal load, and/or
wherein the thermal optimization control (32) is configured to predict an upcoming thermal load in the optimization.
